Europäisches Patentamt

European Patent Office

Office européen des brevets

(19)

(11) Publication number: **0 024 763**

**B1**

(12) # EUROPEAN PATENT SPECIFICATION

(45) Date of publication of patent specification: **06.06.84**

(51) Int. Cl.³: **H 03 D 7/16, H 03 J 7/20, H 04 N 7/04**

(21) Application number: **80200777.3**

(22) Date of filing: **19.08.80**

(54) Converter circuit for television signals.

(30) Priority: **22.08.79 NL 7906336**

(43) Date of publication of application:
**11.03.81 Bulletin 81/10**

(45) Publication of the grant of the patent:
**06.06.84 Bulletin 84/23**

(84) Designated Contracting States:
**BE DE FR GB IT NL SE**

(56) References cited:
**DE - A - 2 205 193**
**US - A - 2 618 743**

**RUNDFUNK TECHNISCHE MITTEILUNGEN, vol. 23, no. 2, April 1979, pages 72-78 Hamburg, DE. H.J. RADDANT: "Steuerbare Fernsehumsetzer für Kabelfernsehanlagen"**

(73) Proprietor: **N.V. Philips' Gloeilampenfabrieken**
**Groenewoudseweg 1**
**NL-5621 BA Eindhoven (NL)**

(72) Inventor: **van de Grijp, Abram**
**c/o INT. OCTROOIBUREAU B.V. Prof. Holstlaan 6**
**NL-5656 AA Eindhoven (NL)**

(74) Representative: **Schoonheijm, Harry Barend et al,**
**INTERNATIONAAL OCTROOIBUREAU B.V.**
**Prof.Holstlaan 6**
**NL-5656 AA Eindhoven (NL)**

## Description

The invention relates to a converter circuit for RF signals having a signal input and a signal output for connection to the aerial input of an RF superheterodyne receiver, comprising a cascade arrangement of an RF signal selector and a modulator connected between the signal input and the signal output.

Such a converter circuit is disclosed in German Patent Application No. 2,205,193 which has been laid open to public inspection, and is used as an adaptor for a TV receiver to enable TV signals which are outside the standard TV frequency range to be displayed. Another converter circuit with a similar signal processing and an AFC is known from the article "Steuerbare Fernsehumsetzer für Kabelfernsehanlagen", by H-J. Raddant, published in "Rundfunktechnische Mitteilungen", Volume 23, no. 2, April 1979, pages 72—78. When using these known circuits the tuning section of the TV receiver is fixedly adjusted to a given TV channel. Selection and conversion of a desired TV signal, which is possibly located outside the standard TV frequency range, to the channel to which the TV receiver has been tuned is effected in the converter circuit. The tuning is varied by operating the converter circuit.

The use of this known converter circuit results in a change in the manner of tuning with which the user must be acquainted. In addition, when the user has a TV receiver with remote control, this convenient feature is lost and he is compelled to operate the converter circuit to tune his TV receiver.

It is an object of the invention to provide a converter circuit which does not affect the manner of tuning a TV or radio receiver. According to the invention, a converter circuit of the type described in the opening paragraph is therefore characterized in that the converter circuit also comprises a coupling circuit including a directional coupler connected to the signal output for coupling the oscillator radiation present at the aerial input of an RF superheterodyne receiver to a frequency search circuit which is connected to the coupling circuit, one output of the search circuit being coupled to the RF signal selector to control the selection of an RF signal from the signals applied to the signal input, another output thereof being coupled to the modulator to control modulation of the selected RF signal on a carrier frequency.

The invention is based on the recognition of the fact that for normal RF superheterodyne receivers the local oscillator signal is parasitically radiated to the aerial input with a measurable amplitude. The frequency of this oscillator radiation indicates the transmitter frequency to which the receiver has been tuned and, consequently, the RF signal which must be applied to the aerial input.

When the measure according to the invention is used, the information as regards the desired RF signal is detected in the frequency search circuit on the basis of the frequency of the oscillator radiation. This information is used to control the RF signal selector, causing the desired RF signal to be selected from the RF signals which are applied to the RF signal selector by way of the signal input, and a modulator which modulates the selected, desired RF signal on a carrier frequency which is determined by the local oscillator frequency. The RF signal obtained in this manner can be processed further and displayed in the customary manner by the RF superheterodyne receiver connected to the converter circuit.

As the converter circuit in accordance with the invention is controlled by the local oscillator frequency of an RF receiver coupled to the converter circuit, the normal manner of tuning the receiver by means of the tuning portion of the RF receiver, which can be operated directly or remotely, is not changed.

As the coupling circuit includes a directional coupler, the oscillation radiation is passed on to the frequency search circuit almost without any attenuation, whereas transmission of the RF signals at the signal output to the frequency search circuit is considerably suppressed.

A further preferred embodiment of a converter circuit according to the invention is characterized in that the frequency search circuit comprises a controllable oscillator a central input of which is connected to a control circuit and an output of which is coupled to a first input of a first mixer stage, this first mixer stage also having a second input to which the coupling circuit is coupled, and also having an output which is coupled to the control circuit by way of a filtering element.

Such a frequency search circuit is known *per se* from United States patent No. 2,618,743. When, however, such a frequency search circuit is used in the converter circuit according to the invention advantageous use is made of the availability of the information about the local oscillator frequency, on the one hand in the form of a direct voltage control signal at the output of the control circuit and on the other hand in the form of a signal frequency at the output of the controllable oscillator. This renders a simple control of the RF signal selector and the modulator possible.

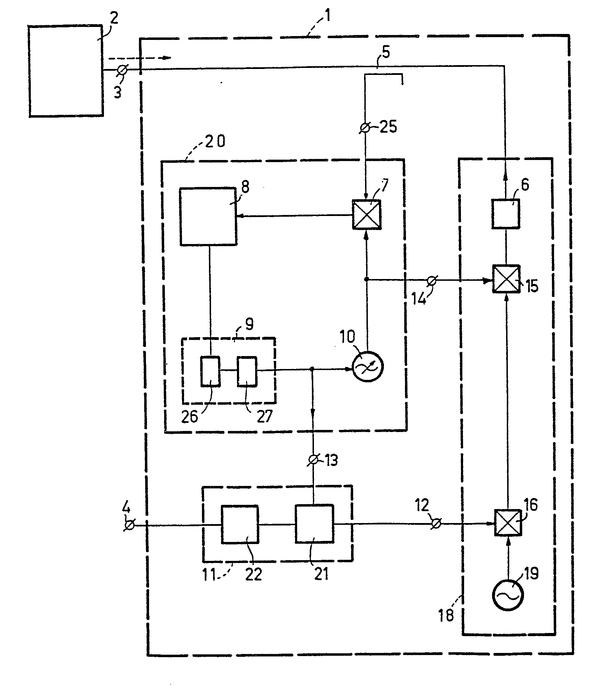

The invention will be further described by way of non-limitative example with reference to the sole Figure of the accompanying drawing.

This Figure shows a converter circuit 1 according to the invention, having an optical signal input 4 and a signal output 3, which is connected to an aerial input of a TV superheterodyne receiver 2.

The converter circuit comprises a frequency search circuit 20, which has an input 25 to which is coupled the signal output 3 *via* a directional coupler 5, which functions as a coupling circuit. A first output 13 of the frequency search circuit 20 is coupled to a control input of a TV signal selector 21, which serves as an RF signal selector and is part of an optical receiver 11. The optical receiver 11 also comprises an optical-to-electrical signal converter 22, which is connected between the optical signal input 4 and TV signal selector 21. An output 12 of the TV signal selector 21 is coupled to a modulator 18, as is a second output 14 of the frequency search circuit 20. The modulator 18 is coupled to the signal output 3.

The frequency search circuit 20 comprises a first mixer stage 7 having first and second input which are fed from the directional coupler 5 and a controllable oscillator 10, respectively. An output of the mixer stage 7 is coupled to a control circuit 9 through a low-pass filter 8. An output of the control circuit 9 is coupled to a control input of the controllable oscillator 10 and also to the first output 13 of the frequency search circuit 20. The connection between the controllable oscillator 10 and the first mixer stage 7 is coupled to the second output 14 of the frequency search circuit 20.

The control circuit 9 comprises a clock 26 which is connected to the low-pass filter and which drives a staircase generator 27. The staircase generator 27 applies a step-wise varying control voltage ramp to the controllable oscillator 10. The controllable oscillator 10 sweeps in each ramp period over a frequency range corresponding to the tuning range of the local oscillator of the TV receiver 2. When an input signal is applied from the low-pass filter 8 to the clock 26, the latter is deactivated and the control voltage then obtained is retained. This ends the sweeping procedure. In an alternative embodiment, not shown, of the control circuit 9, the staircase generator is replaced by a sawtooth oscillator and the frequency of the controllable oscillator 10 is varied continuously over the abovementioned frequency range. A switching device deactivates the sawtooth oscillator at a certain value of the control voltage when an input signal is received which is fed from the low-pass filter 8 to the control circuit 9, causing the sweep procedure to be ended. As a detailed knowledge about the operation of the control circuit 9 is of no importance for an understanding of the invention a further description is not given.

The oscillator radiation of the TV superheterodyne receiver 2 at which radiation is present at the aerial input, is applied almost without attenuation *via* the directional coupler 5 to the first mixer stage 7 of the frequency search circuit 20 where it is multiplied by the signal from the controllable oscillator 10. When the varying frequency of the signal from the controllable oscillator 10 attains the frequency of the oscillator radiation, a direct voltage product is produced at the output of the mixer stage 7, which product passes the low-pass filter 8 and locks the control voltage produced by the control circuit 9 at the value then attained. This causes the oscillator 10 to be locked onto the frequency of the local oscillator of the TV receiver 2.

*Via* the first output 13 of the frequency search circuit 20 the control voltage from the control circuit 9 controls the TV signal selector 21 of the optical receiver 11. This causes the TV signal desired by the user to be selected from the TV signals applied by the optical-to-electrical signal converter 22 to the TV signal selector 21. The selected, desired TV signal appears in the basic frequency band (0 to 5.5 MHz) at the output 12 of the TV signal selector 21. As a detailed knowledge about the operation of the optical receiver 11 is of no importance for an understanding of the invention no further description is given. For further information about optical receivers reference may be made to "An Optical Transmitter and Receiver for Two-way Wavelength-Division-Multiplexing Transmission in the 0.75 $\mu$m Wavelength Region", by H. Ishio, K. Osafune, H. Nakamura and K. Miyazaki, published in "Fourth ECOC, Genova", September 12—15, 1978, pages 449—458.

The desired basic-frequency band TV signal thus obtained at the output 12 is applied to a second mixer stage 16 included in the modulator 18, where a first modulation process is effected by multiplying this TV signnal by the output signal of a fixed frequency oscillator 19 connected to the mixer stage 16. The frequency of this fixed frequency oscillator 19 is chosen equal to the TV intermediate frequency of the TV superheterodyne receiver 2.

An output of the second mixer stage 16 is coupled to an input of a third mixer stage 15, where a second modulation process is effected by multiplying the TV signal, modulated on the TV intermediate frequency, by the signal from the controllable oscillator 10 connected to the mixer stage 15. As mentioned hereinbefore, the frequency of the controllable oscillator 10 is equal to the local oscillator frequency.

In order to select from the mixed products at the output of the mixer stage 15 a TV signal to be processed by the TV receiver 2, this output is coupled to a band-pass filter 6 which passes the TV signal which is modulated on a carrier frequency equal to the sum of the said TV intermediate frequency and the local oscillator frequency. This TV signal, modulated on the said carrier frequency, is applied to the TV superheterodyne receiver 2 *via* the output of the modulator 18. Alternative constructions, embodying the invention, of the converter circuit 1 are of course possible. One of these possibilities is to include in the modulator 18 only one mixer stage in which, in one single modulation process, the basic frequency band TV signal at the output 12 of the TV signal selector 21 is modulated on said carrier frequency. The low-pass filter 8 must then be replaced by a band-pass filter, so that the controllable oscillator 10 can be locked onto the required carrier frequency. The sweeping range of the controllable oscillator 10 must then of course be shifted by an amount equal to the intermediate frequency.

It is alternnatively possible to choose a frequency for the fixed frequency oscillator 19 which is not equal to the TV intermediate frequency. In that case the low-pass filter 8 must again be replaced by a band-pass filter.

Although the converter circuit shown in the drawing is used in fibre optic CATV networks it will be clear that the inventive idea is also used when the converter circuit 1 is made suitable for use in conventional CATV networks by simply replacing the optical receiver 11 by a known electric TV-tuner.

It should be noted that the invention is not limited to the conversion of only TV signals. In a manner which will be obvious for a person having normal skill in the art, the converter circuit 1 can be made suitable for the conversion of other RF signals.

## Claims

1. A converter circuit (1) for RF signals having a signal input (4) and a signal output (3) for connection to the aerial input of an RF superheterodyne receiver (2), comprising a cascade arrangement, connected between the signal input and the signal output, of an RF signal selector (11) and a modulator (18), characterized in that the converter circuit (1) also comprises a coupling circuit (5) including a directional coupler connected to the signal output for decoupling oscillator radiation present at the aerial input (3) of an RF superheterodyne receiver (2) a frequency search circuit (20) connected to the coupling circuit (5), one output of this frequency search circuit (20) being coupled to the RF signal selector (11) to control the selection of an RF signal from RF signals applied to the signal input (4), another output thereof being coupled to the modulator (18) to control modulation of the selected RF signal on a carrier frequency.

2. A converter circuit as claimed in Claim 1, characterized in that the frequency search circuit (20) comprises a controllable oscillator (10) a central input of which is connected to a control circuit (9) and an output of which is coupled to a first input of a first mixer stage (7), this first mixer stage (7) also having a second input to which the coupling circuit (5) is coupled, and also having an output which is coupled to the control circuit (9) through a filter element (8).

3. A converter circuit as claimed in Claim 2, characterized in that the modulator (18) comprises a second mixer stage (16) an input of which is connected to a fixed frequency oscillator (19), and a third mixer stage (15) an input of which is connected to an output of the frequency search circuit (20), these two mixer stages (15, 16) being arranged in cascade between the RF signal selector (11) and the signal output, the said filtering element (8) being a low-pass filter and the frequency of the fixed frequency oscillator (19) being equal to the intermediate frequency of an RF superheterodyne receiver (2) to ve connected to the converter circuit (1).

4. A converter circuit as claimed in any of the preceding Claims, characterized in that the RF signal selector (11) comprises a converter device (22) for converting optical RF signals into electric RF signals.

## Revendications

1. Circuit convertisseur (1) pour des signaux de haute fréquence comportant une entrée (4) de signaux et une sortie (3) de signaux à connecter à l'entrée d'antenne d'un récepteur superhétérodyne (2) à haute fréquence comportant un montage en cascade d'un sélecteur (11) de signaux à haute fréquence et d'un modulateur (18) connecté entre l'entrée de signaux (4) et la sortie de signaux (3), caractérisé en ce qu'il comprend aussi un circuit de couplage (5) comprenant un coupleur directif connecté à la sortie de signaux (3) pour découpler le rayonnement d'oscillateur présent à l'entrée d'antenne d'un récepteur superhétérodyne (2) à haute fréquence, un circuit (20) chercheur de fréquence qui est relié au circuit de couplage (5), une sortie (13) de ce circuit (20) chercheur de fréquence étant couplée au sélecteur (11) de signaux à haute fréquence pour commander la sélection d'un signal à haute fréquence parmi les signaux à haute fréquence appliqués à l'entrée (4) de signaux, une autre sortie (14) de ce circuit (20) étant couplée au modulateur (18) pour commander la modulation du signal à haute fréquence sélectionné sur une fréquence d'onde porteuse.

2. Circuit convertisseur selon la revendication 1, caractérisé en ce que le circuit chercheur (20) de fréquence comprend un oscillateur réglable (10) dont une entrée de réglage est connectée à un circuit de réglage (9) et dont une sortie est couplée à une première entrée d'un premier étage mélangeur (7) également pourvu d'une seconde entrée couplée au circuit de couplage (5) ainsi que d'une sortie qui est couplée au circuit de réglage (9) par l'intermédiaire d'un élément de filtrage (8).

3. Circuit convertisseur selon la revendication 2, caractérisé en ce que le modulateur (18) comporte un deuxième étage mélangeur (16) dont une entrée est connectée à un oscillateur (19) à frequence fixe, et un troisième étage mélangeur (15) dont une entrée est couplée à une sortie (14) du circuit (20) chercheur de fréquence, ces deux étages mélangeurs (15, 16) étant disposés en cascade entre le sélecteur (11) de signaux à haute fréquence et la sortie de signaux (3), ledit élément de filtrage (8) étant un filtre passe-bas et la fréquence de l'oscillateur (19) à fréquence fixe étant égale à la fréquence intermédiaire d'un récepteur superhétérodyne (2) à haute fréquence à connecter au circuit convertisseur (1).

4. Circuit convertisseur selon l'une quelconque des revendications précédentes, caractérisé en ce que le sélecteur (11) de signaux à haute fréquence comporte un dispositif convertisseur (22) servant à convertir des signaux optiques à haute fréquence en signaux électriques à haute fréquence.

**Patentansprüche**

1. Konverterschaltung (1) für HF-Signale mit einem Signaleingang (4) und einem Signalausgang (3) zum Anschluss an den Antenneneingang eines HF-Ueberlagerungsempfängers (2) mit einer zwischen dem Signaleingang und dem Signalausgang liegenden Kaskadenschaltung aus einem HF-Signalwähler (11) und einem Modulator (18), dadurch gekennzeichnet, dass die Konverterschaltung (1) zugleich mit einer mit dem Signalausgang verbundenen Koppelschaltung (5) zum Auskoppeln am Antenneneingang (3) eines HF-Ueberlagerungsempfängers (2) vorhandener Oszillatorstörstrahlung und einer mit der Koppelschaltung (5) verbundenen Frequenzsuchschaltung (20) versehen ist, die einerseits mit dem HF-Signalwähler (11) zur Steuerung einer Wahl eines HF-Signals aus dem Signaleingang (4) zugeführten HF-Signalen und andererseits mit dem Modulator (18) zur Steuerung der Modulation des gewählten HF-Signals auf einer Trägerfrequenz verbunden ist.

2. Konverterschaltung nach Anspruch 1, dadurch gekennzeichnet, dass die Frequenzsuchschaltung (20) einen Steuerbaren Oszillator (10) enthält dessen zentraler Eingang mit einer Steuerschaltung (9) und dessen Ausgang mit einem ersten Mischstufe (7) verbunden ist, die zugleich mit einem zweiten Eingang versehen ist, der mit der Koppelschaltung (5) verbunden ist, sowie mit einem Ausgang, der über ein Filterelement (8) mit der Regelschaltung (9) gekoppelt ist.

3. Konverterschaltung nach Anspruch 2, dadurch gekennzeichnet, dass der Modulator (18) eine mit einem Oszillator (19) mit fester Frequenz verbundene zweite Mischstufe (16) enthält sowie eine mit einem Ausgang der Frequenzsuchschaltung (20) verbundene dritte Mischstufe (15), dass die beiden Mischstufen (15, 16) in Kaskade und zwischen den HF-Signalwähler (11) und den Signalausgang geschaltet sind, und dass das Filterelement (8) ein Tiefpassfilter ist und die Frequenz des Oszillators (19) mit fester Frequenz der Zwischenfrequenz eines an die Konverterschaltung (11) anzuschliessenden HF-Ueberlagerungsempfängers (2) entspricht.

4. Konverterschaltung nach einem der vorstehenden Ansprüche, dadurch gekennzeichnet, dass der HF-Signalwähler (11) einen Wandler (22) enthält zum Umwandeln optischer HF-Signale in elektrische HF-Signale.